# EUROPÄISCHE PATENTANMELDUNG

(11) **EP 3 975 672 A1**
(43) Veröffentlichungstag der Anmeldung: **30.03.2022**
(21) Anmeldenummer: 21192088.9
(22) Anmeldetag: 19.08.2021
(51) Int. Cl.: H05K 3/24, H05K 3/32, H01R 25/14, H05K 1/11, F21S 4/28, F21V 17/10, F21V 19/00, F21V 21/02, F21V 21/096, F21V 21/35, C23C 18/00

(54) **BELEUCHTUNGSVORRICHTUNG**

(30) Priorität: 23.09.2020 AT 508082020
(71) Anmelder: Molto Luce GmbH, 4616 Weisskirchen (AT)
(72) Erfinder: Hinterberger, Daniel, 4722 Peuerbach (AT); Windischbauer, Franz, 4616 Weißkirchen an der Traun (AT)
(74) Vertreter: Hübscher & Partner Patentanwälte GmbH

(57) **Zusammenfassung**

Es wird eine Beleuchtungsvorrichtung mit einem sich in einer Längsrichtung erstreckenden Trägerprofil (1), das eine in einer Aufnahme (2) verlaufende Leiterplatte (5) mit einer Leiterbahn (6) zur Gleitkontaktierung einer gegenüber der Leiterbahn (6) in Längsrichtung verschiebbaren Beleuchtungseinheit (7) umfasst, beschrieben. Um eine Beleuchtungsvorrichtung der eingangs geschilderten Art so auszugestalten, dass bei zuverlässigen elektrischen Kontaktbedingungen ein ansprechendes Erscheinungsbild trotz eines etwaigen Neuausrichtens, eines Austausches oder eines nachträglichen Hinzufügens von Beleuchtungseinheiten nachhaltig erhalten bleibt, wird vorgeschlagen, dass die in der Aufnahme (2) sichtbare Oberfläche (8) der Leiterbahn (6) einen galvanischen Überzug (9) aufweist.

## Beschreibung

Die Erfindung bezieht sich auf eine Beleuchtungsvorrichtung mit einem sich in einer Längsrichtung erstreckenden Trägerprofil, das eine in einer Aufnahme verlaufende Leiterplatte mit einer Leiterbahn zur Gleitkontaktierung einer gegenüber der Leiterbahn in Längsrichtung verschiebbaren Beleuchtungseinheit umfasst.

Aus dem Stand der Technik sind Beleuchtungsvorrichtungen mit einem sich in einer Längsrichtung erstreckenden Trägerprofil, beispielsweise einem stranggepressten Aluminiumprofil mit U- bzw. H-förmigem Querschnitt, bekannt (EP 3321562 A1). In einer Aufnahme des Trägerprofils ist eine Leiterplatte zur Gleitkontaktierung und somit elektrischen Versorgung wenigstens einer bezüglich der Längsrichtung gegenüber der Leiterplatte verschiebbaren Beleuchtungseinheit untergebracht. Zur Verbindung der Leiterplatte mit einer Beleuchtungseinheit kann letztere an einem offenen Endabschnitt des Trägerprofils seitlich in innenliegende Führungsschienen eingeschoben werden, sodass eine elektrische Kontaktierung zwischen den jeweiligen elektrischen Kontaktstellen der Beleuchtungseinheit und der Leiterplatte erfolgen kann. Um bei einem derartigen Verbindungsvorgang eine Funkenbildung aufgrund der gleitenden Relativbewegung zwischen den Kontaktstellen der Beleuchtungseinheit und der Leiterplatte weitgehend zu vermeiden und darüber hinaus ein optisch ansprechendes Erscheinungsbild zu ermöglichen, ist die der Beleuchtungseinheit zugewandte, im Einbauzustand vom Benutzer sichtbare Oberfläche der Leiterplatte mitsamt den darauf befindlichen Kontaktstellen mit einer siebgedruckten Graphitbeschichtung versehen. Nachteilig ist daran allerdings, dass die graphitbeschichteten Kontaktstellen im Hinblick auf zuverlässige elektrische Kontaktbedingungen grundsätzlich einen zu hohen Übergangswiderstand aufweisen. Um diesen entsprechend zu verringern, müsste die Kontaktkraft erhöht werden. Zufolge der Erhöhung der Kontaktkraft würde jedoch bedingt durch die geringe Oberflächenhärte der siebgedruckten Graphitbeschichtung kein beschädigungsfreies Verschieben der Beleuchtungseinheit am Trägerprofil mehr möglich sein. Insbesondere erlauben derartige vorbekannte Beleuchtungsvorrichtungen somit keine Neuausrichtung oder einen Austausch der Beleuchtungseinheit bzw. ein nachträgliches Hinzufügen weiterer Beleuchtungseinheiten, ohne dass damit Einbußen im Erscheinungsbild aufgrund der dann beschädigten Graphitbeschichtung einhergehen.

Der Erfindung liegt somit die Aufgabe zugrunde, eine Beleuchtungsvorrichtung der eingangs geschilderten Art so auszugestalten, dass bei zuverlässigen elektrischen Kontaktbedingungen ein ansprechendes Erscheinungsbild trotz eines etwaigen Neuausrichtens, eines Austausches oder eines nachträglichen Hinzufügens von Beleuchtungseinheiten nachhaltig erhalten bleibt.

Die Erfindung löst die gestellte Aufgabe dadurch, dass die in der Aufnahme sichtbare Oberfläche der Leiterbahn einen galvanischen Überzug aufweist.

Es hat sich überraschenderweise herausgestellt, dass durch eine Abscheidung metallischer Niederschläge auf die sichtbare Oberfläche der Leiterbahn in einem elektrolytischen Bad auf einfache und effiziente Weise Überzüge mit gleichmäßiger Schichtdicke geschaffen werden, die in Bezug auf sowohl den Übergangswiderstand als auch die Abriebfestigkeit besonders günstige Eigenschaften ausbilden. Dadurch kann ein problemloses elektrisches Kontaktieren der Leiterplatte mit etwaigen Beleuchtungseinheiten erfolgen, sowie ein für die sichtbare Oberfläche der Leiterbahn bzw. Leiterplatte beschädigungsfreies Verschieben der Beleuchtungseinheiten relativ zur Leiterbahn bzw. Leiterplatte ermöglicht werden. Insbesondere im Hinblick auf einfache Fertigungsbedingungen kann es besonders vorteilhaft sein, wenn die Leiterbahn vollständig in der Leiterplatte eingebettet ist. Dadurch können die Leiterbahnen der vorzugsweise am sichtbaren Aufnahmegrund des Trägerprofils angeordneten Leiterplatte an ihrer sichtbaren Oberfläche im Wesentlichen vollständig mit einem galvanischen Überzug versehen werden, wobei zur Vermeidung von Kurzschlüssen zwischen den Leiterbahnen entsprechende Leiterplattenbereiche vorzugsweise mit einem schwarzen Lötstopplack überzogen werden. Grundsätzlich ist aber auch denkbar, dass zusätzlich zu der auf der Leiterplatte verlaufenden Leiterbahn eine weitere Leiterbahn entlang einer der vom Aufnahmegrund seitlich dazu hochragenden, üblicherweise vom Benutzer nicht sichtbaren innenliegenden Aufnahmewände verläuft. Vorzugsweise sind jedoch beide Leiterbahnen auf der Leiterplatte angeordnet. Insbesondere im Zusammenhang mit indirekt abstrahlenden Beleuchtungseinheiten kann je nach Wahl des Elektrolyten der galvanische Überzug dergestalt sein, dass neben einem ansprechenden Erscheinungsbild der sichtbaren Oberfläche der Leiterbahn bzw. Leiterplatte auch eine zusätzliche Reflexionsschicht gebildet wird, sodass eine verbesserte Abstrahlcharakteristik der Beleuchtungsvorrichtung ermöglicht wird.

Um einen Überzug bereitzustellen, der bei guten elektrischen Kontaktierungsbedingungen ein nachhaltig ansprechendes, insbesondere dunkles Erscheinungsbild der Leiterbahnoberfläche schafft, empfiehlt es sich, dass der galvanische Überzug aus einem Chrom- oder Nickelelektrolyten abgeschieden ist. Obwohl derartige Schwarzchrom- oder Schwarznickelüberzüge grundsätzlich eine geringere Abriebfestigkeit aufweisen und somit anfälliger für Oberflächenbeschädigungen sind, die das optische Erscheinungsbild beeinträchtigen, konnte eine wirksame Verbesserung der Abriebfestigkeit beobachtet werden, wenn der Chrom- oder Nickelelektrolyt bei einer Stromdichte von 8 bis 12 A / dm², vorzugsweise 10 A / dm² abgeschieden wird.

Das Vorsehen eines galvanischen Überzugs ermöglicht zwar eine problemlose und zuverlässige elektrische Kontaktierung zwischen Beleuchtungseinheiten und der Leiterbahn, allerdings sind derartige Überzüge dennoch nicht ohne weiteres dafür geeignet, mehrere Beleuchtungsvorrichtungen über die üblicherweise verwendeten Steckverbinder elektrisch miteinander zu verbinden, weil der sich zwischen dem galvanischen Überzug und der Kontaktstelle eines entsprechenden Steckverbinders einstellende Übergangsleitwert hierfür nicht ausreichend ist. Um vor diesem Hintergrund dennoch mehrere erfindungsgemäße Beleuchtungsvorrichtungen zuverlässig über Steckverbinder elektrisch miteinander verbinden zu können wird vorgeschlagen, dass die Leiterbahn eine verzinnte Anschlussstelle für einen Steckverbinder aufweist. Eine solche Anschlussstelle kann beispielsweise dadurch geschaffen werden, dass die Leiterbahn vor dem Aufbringen des galvanischen Überzuges im Bereich der auszubildenden Anschlussstelle mit einem ungalvanisierbaren Schutzelement versehen wird, wonach der galvanische Überzug auf die Leiterbahn bzw. Leiterplatte aufgebracht wird. Das Schutzelement kann beispielsweise durch ein Polyesterklebeband oder aber auch durch abziehbare bzw. durch alkalische Tauchbäder wieder ablösbare Lötstopplacke gebildet werden. Wichtig ist in jedem Fall, dass das Schuzelement beim Galvanisieren der Leiterbahnen ein unerwünschtes Aufbringen des galvanischen Überzugs auf die Anschlussstelle verhindert, wobei das Schutzelement nach dem Galvanisierungsvorgang auf einfache Weise wieder entfernt werden kann. Dadurch ist die Anschlussstelle unter besonders geringen Übergangswiderstandswerten elektrisch kontaktierbar bzw. kann die Anschlussstelle gegebenenfalls mit einer zusätzlichen, einen geringen Übergangswiderstand ausbildenden Kontaktschicht, beispielsweise auf Zinnbasis, versehen werden. Für den Fall, dass das erfindungsgemäße Schutzelement als Schutzlack ausgebildet ist, der mithilfe eines alkalischen Tauchbades wieder entfernt werden kann, empfiehlt es sich, dass das Tauchbad einen pH-Wert über 9, vorzugsweise über 12 aufweist. Obwohl es bekannt ist, dass insbesondere durch Schwarzchromelektrolyten abgeschiedene galvanische Überzüge ebenfalls empfindlich gegenüber alkalische Lösungen sind, wird in jenem pH-Wertbereich zum Entfernen des Schutzlackes lediglich eine so geringe Eintauchzeit benötigt, dass der galvanische Überzug beschädigungsfrei bleibt. Für besonders gute elektrische Kontaktierungsbedingungen kann auf die vom Schutzelement befreite Anschlussstelle eine beispielsweise über Heißluftverzinnung erzeugte Kontaktschicht aufgebracht werden, sodass ein geringer Übergangswiderstand erreicht wird.

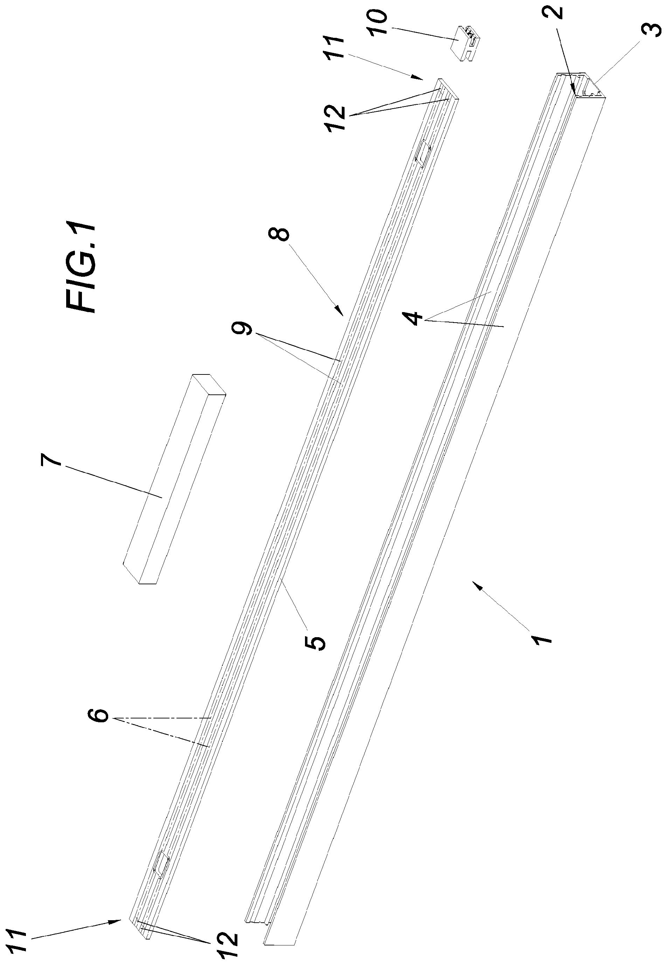

In der Zeichnung ist der Erfindungsgegenstand beispielsweise dargestellt. Es zeigen
- Fig. 1: eine Explosionsdarstellung einer erfindungsgemäßen Beleuchtungsvorrichtung und
- Fig. 2: einen Längsschnitt durch eine erfindungsmäße Leiterplatte.

Eine erfindungsgemäße Beleuchtungsvorrichtung kann an einer baulichen Einrichtung, insbesondere einer Decke montiert werden und umfasst ein sich in einer Längsrichtung erstreckendes Trägerprofil 1. Dieses weist beispielsweise einen U-förmigen Querschnitt auf und bildet eine Aufnahme 2 mit einem Aufnahmegrund 3 sowie Aufnahmewände 4, die vom Aufnahmegrund 3 an dessen Längsseiten hochragen, aus. In die Aufnahme 2 ist eine Leiterplatte 5 eingesetzt. Die Leiterplatte 5 kann beispielsweise in Führungsschienen des Trägerprofils 1 eingeschoben sein, oder aber auch magnetisch am Trägerprofil 1 bzw. an einem nicht näher dargestellten, in das Trägerprofil 1 eingeschobenen Unterlegeblech befestigt sein. Auf der Leiterplatte 5 können zwei Leiterbahnen 6 verlaufen, welche aus Gründen der einfacheren Darstellung als strichpunktierte Linien angedeutet werden.

Darüber hinaus umfasst die Beleuchtungsvorrichtung wenigstens eine Beleuchtungseinheit 7, deren nicht näher dargestellten Kontaktstellen über eine Gleitkontaktierung elektrisch mit den Leiterbahnen 6 der Leiterplatte 5 verbunden sind. Aufgrund der Gleitkontaktierung ist die Beleuchtungseinheit 7 gegenüber den Leiterbahnen 6 in Längsrichtung des Trägerprofils 1 verschiebbar. Damit bei zuverlässigen elektrischen Kontaktbedingungen ein ansprechendes Erscheinungsbild trotz eines etwaigen Neuausrichtens, eines Austausches oder eines nachträglichen Hinzufügens von Beleuchtungseinheiten 7 nachhaltig erhalten bleibt, weist die in der Aufnahme sichtbare Oberfläche 8 der Leiterbahnen 6 einen galvanischen Überzug 9 auf. Für ein besonders ansprechendes, dunkles Erscheinungsbild kann der galvanische Überzug 9 beispielsweise von einem Chromelektrolyten bei einer Stromdichte von 8 bis 12 A / dm², vorzugsweise 10 A / dm² abgeschieden worden sein. Um Kurzschlüsse zwischen den Leiterbahnen 6 zu vermeiden, kann insbesondere der Leiterplattenbereich zwischen den Leiterbahnen 6 vorzugsweise mit einem schwarzen Lötstopplack überzogen sein.

Um mehrere erfindungsgemäße Beleuchtungsvorrichtungen zuverlässig über Steckverbinder 10 elektrisch miteinander zu verbinden, können die Leiterbahnen 6 eine verzinnte Anschlussstelle 11 für einen Steckverbinder 10 aufweisen. Eine solche Anschlussstelle 11 kann beispielsweise dadurch geschaffen werden, dass die Leiterbahnen 6 vor dem Aufbringen des galvanischen Überzuges 9 im Bereich der auszubildenden Anschlussstelle 11 mit einem ungalvanisierbaren Schutzlack als Schutzelement versehen werden. Nachdem der galvanische Überzug 9 auf die Leiterbahnen 6 bzw. die Leiterplatte 5 aufgebracht worden ist, kann der Schutzlack mithilfe eines alkalischen Tauchbades zur Entfettung bei einem pH-Wert über 9, vorzugsweise über 12 wieder entfernt und durch eine über beispielsweise Heißluftverzinnung erzeugte Kontaktschicht 12 ersetzt werden.

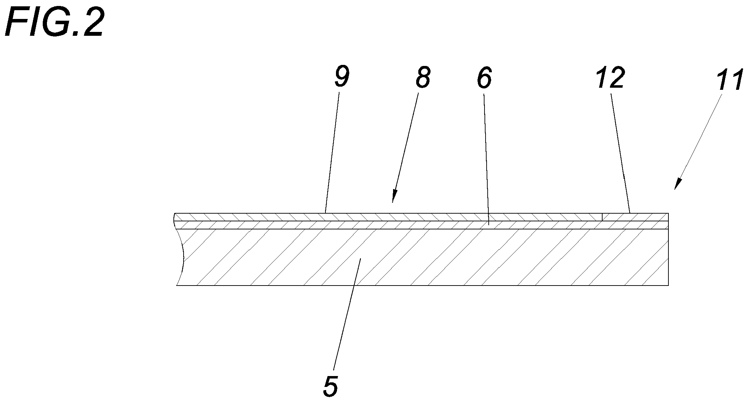

Mit Blick auf Fig. 2 wird der Schichtaufbau auf einer erfindungsgemäßen Leiterplatte 5 in vereinfachter Darstellung anhand eines Längsschnittes verdeutlicht. Die in der Aufnahme 2 sichtbare Oberfläche 8 der Leiterbahn 6 weist einen galvanischen Überzug 8 auf. Zudem weist die Leiterbahn 6 eine Anschlussstelle 11 mit einer Kontaktschicht 12 aus Zinn auf.

## Patentansprüche

1. Beleuchtungsvorrichtung mit einem sich in einer Längsrichtung erstreckenden Trägerprofil (1), das eine in einer Aufnahme (2) verlaufende Leiterplatte (5) mit einer Leiterbahn (6) zur Gleitkontaktierung einer gegenüber der Leiterbahn (6) in Längsrichtung verschiebbaren Beleuchtungseinheit (7) umfasst, **dadurch gekennzeichnet, dass** die in der Aufnahme (2) sichtbare Oberfläche (8) der Leiterbahn (6) einen galvanischen Überzug (9) aufweist.

2. Beleuchtungsvorrichtung nach Anspruch 1, **dadurch gekennzeichnet, dass** der galvanische Überzug (9) aus einem Chrom- oder Nickelelektrolyten abgeschieden ist.

3. Beleuchtungsvorrichtung nach Anspruch 1 oder 2, **dadurch gekennzeichnet, dass** die Leiterbahn (6) eine verzinnte Anschlussstelle (11) für einen Steckverbinder (10) aufweist.

4. Verfahren zur Herstellung einer Leiterplatte (5) für eine Beleuchtungsvorrichtung nach Anspruch 3, **dadurch gekennzeichnet, dass** die Leiterplatte (5) vor dem Aufbringen des galvanischen Überzuges (9) im Bereich der auszubildenden Anschlussstelle (11) mit einem ungalvanisierbaren Schutzelement versehen wird und dass nach Aufbringen des galvanischen Überzugs (9) auf die Leiterplatte (5) das Schutzelement wieder entfernt und eine zinnbasierte Kontaktschicht (12) unter Ausbildung der Anschlussstelle (11) für einen Steckverbinder (10) auf die Leiterplatte (5) aufgebracht wird.
